# EUROPÄISCHE PATENTANMELDUNG

(11) **EP 2 548 729 A1**
(43) Veröffentlichungstag der Anmeldung: **23.01.2013**
(21) Anmeldenummer: 11175088.1
(22) Anmeldetag: 22.07.2011
(51) Int. Cl.: B32B 17/10, C08F 8/28, C08J 5/18, C08K 5/00, C08K 5/10

(54) **Folien aus weichmacherhaltigem Polyvinyl(iso)acetal**

(71) Anmelder: Kuraray Europe GmbH, 65926 Frankfurt am Main (DE)
(72) Erfinder: Meise, Markus, Dr., 65185 Wiesbaden (DE); Steuer, Martin, Dr., 68535 Liederbach (DE); Frank, Michael, Dr., 55268 Nieder-Olm (DE); Beekhuizen, Jan, Dr., 53844 Troisdorf (DE); Keller, Uwe, Dr., 53177 Bonn (DE)
(74) Vertreter: Kisters, Michael Marcus

(57) **Zusammenfassung**

Die Erfindung betrifft Folien enthaltend eine Mischung aus mindestens einem nicht-aromatischen Weichmacher und einem Polyvinyl(iso)acetal mit einem Anteil an Polyvinyl(iso)acetalgruppen von 60 - 95 Gew.% und einem Anteil an Polyvinylalkoholgruppen von 15 - 40 Gew.%.

Verwendung der Folien im Automobilbereich, in Windschutzscheiben, im Architekturbereich, in Fassadenbauteilen oder zur Herstellung von Photovoltaikmodulen.

## Beschreibung

### Technisches Gebiet

Die Erfindung betrifft weichmacherhaltige Folien auf der Basis von Polyvinyl(iso)acetalen, die z.B. als Zwischenschicht in Verbundsicherheitsgläsern oder Klebefolie in Photovoltaikmodulen geeignet ist.

### Stand der Technik

Verbundsicherheitsgläser bestehen im Allgemeinen aus zwei Glasscheiben und einer die Glasscheiben verbindenden Zwischenfolie. Als Folienmaterial wird überwiegend weichmacherhaltiges Polyvinylbutyral (PVB) verwendet, erhältlich aus der Umsetzung von Polyvinylalkohol mit n-Butyraldehyd.

Die mechanische Festigkeit und die Feuchtigkeitsaufnahme solcher Folien wird unter anderem durch die Art und Menge des Weichmachers bestimmt. Polyvinylbutyral besitzt für jeden Weichmacher eine unterschiedliche Aufnahmekapazität oberhalb der der Weichmacher wieder ausschwitzt.

Um eine PVB-Folie mit Erweichungstemperaturen im Bereich üblicher Anwendungstemperaturen (0 - 40 °C) zu erhalten, müssen bestimmte Rahmenbedingungen in Bezug auf die chemische Natur des PVB und des Weichmachers sowie die Mischungsverhältnisse mit dem Weichmacher eingehalten werden. Als Weichmacher für PVB-Folien hat sich mittlerweile 3G8 (Triethylenglykol-bis-2-ethyl-hexanoat durchgesetzt. Für diesen Weichmacher beschreibt EP 0877665 die Aufnahmekapazitäten von PVB mit unterschiedlichen Restvinylalkoholgehalten.

Die bekannten PVB-Folien auf Basis von n-Butyraldehyd besitzen neben einer begrenzten Weichmacheraufnahme eine relativ große Feuchteaufnahme, was in Verbundverglasungen zu unerwünschten

Trübungen führen kann. In der Verwendung in Photovoltaikmodulen kann die hohe Feuchteaufnahme zu einem niedrigen Durchgangswiederstand führen, was unerwünscht ist. Zudem kann eine Aufnahme von Feuchtigkeit zum Ausschwitzen von Weichmacher, insbesondere bei erhöhten Temperaturen, führen.

Es wäre daher wünschenswert, Mischungen von PVB mit höheren Anteilen an unpolaren Weichmachern zur Folienherstellung zu verwenden, um der unerwünschten Feuchtigkeitsaufnahme entgegen zu wirken.

Überraschenderweise wurde gefunden, dass Polyvinyl(iso)acetale eine gegenüber Polyvinyl(n)acetalen größere Weichmacherverträglichkeit aufweisen.

Mischungen von Polyvinyl(iso)acetal mit Dibutylphatalat als Weichmacher sind durch J. Fitzhugh und R Croizer J. Polym. Sci (1951) Vol VIII, S. 225-241 beschrieben. Diese Publikation betrifft nicht die Herstellung von Folien und deren Verwendung. Zudem werden hier ausschließlich polare aromatische Weichmacher verwendet.

Weichmacherhaltige Polyvinyl(iso)acetale sind weiterhin aus US 2008/0286542 zur Herstellung von Zwischenschichtfilmen für dekorative Glaselemente bekannt. Die hier beschriebenen Polyvinyl(iso)acetale weisen für Verbundsicherheitsverglasungen einen zu niedrigen Acetalisierungsgrad von 8-30 Gew.% und damit eine ungenügende Weichmacheraufnahme auf. Dementsprechend offenbart US 2008/0286542 nur Mehrschichtfolien, bei denen weichmacherhaltiges Polyvinyl(iso)acetal mit niedrigem Acetalisierungsgrad zwischen zwei Schichten von weichmacherhaltigem Polyvinyl(n)acetal einlaminiert ist.

Überraschend wurde gefunden, dass Polyvinyl(iso)acetale eine bessere Weichmacherverträglichkeit bei gleichem Polyvinylakoholgehalt (PVA-Gehalt) aufweisen als entsprechende Polyvinyl(n)acetale.

Gegenstand der der vorliegenden Erfindung sind Folien enthaltend eine Mischung aus mindestens einem nicht-aromatischen Weichmacher und einem Polyvinyl(iso)acetal mit einem Anteil an Polyvinyl(iso)acetalgruppen von 60 - 85 Gew.% und einem Anteil an Polyvinylalkoholgruppen von 14 - 40 Gew.%.

Eine bessere Weichmacherverträglichkeit resultiert in einem geringeren Ausschwitzen des Weichmachers aus einer Mischung mit Polyvinyl(iso)acetalen bei Lagerung unter Raumtemperatur. Ein Ausschwitzen von Weichmacher macht sich durch einen Weichmacherfilm auf der Folienoberfläche bemerkbar.

Ausschwitzen von Weichmacher bedeutet mangelnde Verträglichkeit des Polymers mit dem Weichmacher. Dieser Effekt kann durch den sogenannten Trübungspunkt bestimmt werden. Hierbei wird die Verträglichkeit eines Polyvinylacetals mit einem Weichmacher wie z.B. 3G8 getestet, indem eine heiße Lösung des Polyvinylacetals in dem betreffenden Weichmacher langsam abgekühlt wird. Je tiefer die Temperatur ist, bei der eine Trübung der Lösung auftritt, desto verträglicher ist das Polymere mit dem Weichmacher.

Es konnte festgestellt werden, dass die Trübungspunkte für Polyvinylacetale auf Basis iso-Butyraldhyd signifikant tiefer liegen als die gleichen Polyvinylacetale auf Basis n-Butyraldehyd. Dies hat zur Folge, das die erfindungsgemäßen Folien bei gegebenem PVA-Gehalt des verwendeten Polyvinyl(iso)acetals mehr Weichmacher enthalten, als Folien auf Basis von Polyvinyl-n-butyral mit gleichem PVA-Gehalt. Ein höherer Weichmachergehalt bewirkt eine kostengünstigere Produktion der Folie, da die Weichmacher in der Regel preisgünstiger sind als das Polyvinylacetal.

Erfindungsgemäße Folien enthalten keine aromatischen Weichmacher d.h. keine Weichmacher mit einer aromatischen Teilstruktur wie z.B. Phthalate (insbesondere kein Dibutylphthalat) oder Benzoate.

Die erfindungsgemäßen Folien enthalten weichmacherhaltige Polyvinyl(iso)acetale, die durch Acetalisierung eines ganz oder teilweise verseiften Polyvinylalkohols mit verzweigten Ketoverbindungen erhalten werden.

Bevorzugt resultieren die Polyvinyl(iso)acetalgruppen des Polyvinyl(iso)acetals aus der Umsetzung von mindestens einem Polvinylalkohol mit einer oder mehreren aliphatischen Ketoverbindung mit 4 bis 10 Kohlenstoffatomen mit mindestens einer Verzweigung an der alpha- oder beta-Position zur Ketogruppe. Es ist auch möglich, zusätzlich unverzweigte aliphatische Ketoverbindungen mit 2 - 10 Kohlenstoffatomen zur Acetalisierung einzusetzen. Jedoch sollte der Anteil an verzweigten Ketoverbindungen bei mehr als 50 Gew.% der Summe aus verzweigten und unverzweigten Ketoverbindungen liegen.

Der Polyvinylalkoholgehalt der Polyvinyl(iso)acetale kann durch die Menge des bei der Acetalisierung eingesetzten Aldehyds eingestellt werden. Es ist auch möglich, die Acetalisierung mit mehreren Aldehyden durchzuführen.

Der Polyvinylacetatgehalt der erfindungsgemäß verwendeten Polyvinyl(iso)acetale kann durch Verwendung eines zu einem entsprechenden Anteil hydrolisierten Polyvinylalkohols eingestellt werden. Durch den Polyvinylacetatgehalt wird die Polarität des Polyvinyl(iso)acetals beeinflusst, wodurch sich auch die Weichmacherverträglichkeit der Folie ändert. Bevorzugt enthalten die erfindungsgemäßen Folien ein Polyvinyl(iso)acetal mit einem Anteil an Polyvinylacetatgruppen von 0,1 bis 15 Gew.%, bevorzugt 5 bis 15 Gew.% oder 0,1 bis 3 Gew.%.

Der Einsatz von vernetzten Polyvinyl(iso)acetalen insbesondere vernetztem Polyvinyl(iso)butyral ist ebenso möglich. Geeignete Methoden zur Vernetzung sind z.B. in EP 1527107 B1 und WO 2004/063231 A1 (thermische Selbstvernetzung von Carboxylgruppenhaltigen Polyvinylacetalen), EP 1606325 A1 (mit Polyaldehyden vernetzte Polyvinylacetale) und WO 03/020776 A1 (mit Glyoxylsäure vernetzte Polyvinylacetale) beschrieben.

Um die Verarbeitung der Folien nicht zu beeinträchtigen, ist der Einsatz von vernetzten Polyvinyl(iso)acetalen, das im Vergleich zu dem jeweiligen unvernetzten Material eine um 25 bis 200 % vergrößerte Lösungsviskosität aufweist, besonders bevorzugt. So kann z.B. das unvernetzte Material eine Lösungsviskosität von 80 mPas und das vernetzte Material eine Lösungsviskosität von 100 - 250 mPas aufweisen. Zur Herstellung von vernetzten Polyvinyl(iso)acetalen bietet sich die Coacetalisierung von Polyvinylalkoholen mit einem Gemisch aus den genannten Ketoverbindungen und Di- oder Trialdehyden wie z.B. Glutardialdehyd gemäß WO 03/020776 A1 an.

Zur Herstellung von Polyvinyl(iso)acetal wird Polyvinylalkohol in Wasser gelöst und mit einer Ketoverbindung wie iso-Butyraldehyd unter Zusatz eines Säurekatalysators acetalysiert. Das ausgefallene Polyvinylacetal wird abgetrennt, neutral gewaschen, ggf. in einem alkalisch eingestellten wässrigen Medium suspendiert, danach erneut neutral gewaschen und getrocknet.

Die Polyvinylalkohole können im Rahmen der vorliegenden Erfindung rein oder als Mischung von Polyvinylalkoholen mit unterschiedlichem Polymerisationsgrad oder Hydrolysegrad eingesetzt werden.

Allgemein sinkt die Verträglichkeit von Weichmacher und Polyvinylacetalen mit der Abnahme des polaren Charakters des Weichmachers. So sind Weichmacher höherer Polarität mit Polyvinylacetal besser verträglich als solche mit niedrigerer Polarität. Alternativ steigt die Verträglichkeit von Weichmachern geringer Polarität mit Zunahme des Acetalysierungsgrades, d.h. mit Abnahme der Anzahl an Hydroxygruppen und damit der Polarität des Polyvinylacetals.

Aufgrund der Verzweigungen der Acetalgruppe besitzen die erfindungsgemäßen Folien andere Erweichungstemperaturen als herkömmliche, auf geradkettigen Aldehyden basierende Systeme.

Erfindungsgemäße Folien weisen bevorzugt eine Erweichungstemperatur Tg von -11 bis 24 °C auf.

Die Erweichungstemperaturen spielen, neben dem Feuchtegehalt, für den elektrischen Durchgangswiderstand von Folien auf Basis von Polyvinylacetal eine große Rolle. So zeigen erfindungsgemäße Folien eine höhere Erweichungstemperatur und auch einen höheren elektrischen Durchgangswiderstand bei gegebener Feuchte und Temperatur als Folien auf Basis von Polyvinyl(n)acetal mit gleichem Weichmachergehalt.

Dies ist für den Einsatz in Photovoltaik-Modulen von Vorteil, da der elektrische Durchgangswiderstand für die Langlebigkeit der Module wichtig ist.

Die erfindungsgemäßen Folien können Weichmacher oder Weichmachermischungen aus mindestens einem der folgenden nicht-aromatischen Weichmacher enthalten:
- Ester von mehrwertigen aliphatischen Säuren, z.B. Dialkyladipate wie Dihexyladipat, Dioctyladipat, Hexylcyclohexyladipat, Mischungen aus Heptyl- und Nonyladipaten, Diisononyladipat, Heptylnonyladipat sowie Ester der Adipinsäure mit cycloaliphatischen oder Etherbindungen enthaltenden Esteralkoholen, Dialkylsebazate wie Dibutylsebazat sowie Ester der Sebazinsäure mit cycloaliphatischen oder Etherbindungen enthaltenden Esteralkoholen, Estern der Cyclohexandicarbonsäure wie etwa 1,2-Cyclohexandicarbonsäurediisononylester
- Ester oder Ether von mehrwertigen aliphatischen Alkoholen oder Oligoetherglykolen mit einem oder mehreren unverzweigten oder verzweigten aliphatischen Substituenten, wie z.B. Estern von Di-, Tri- oder Tetraglykolen mit linearen oder verzweigten aliphatischen oder cycloaliphatischen Carbonsäuren; Als Beispiele für letztere Gruppe können dienen Diethylenglykol-bis-(2-ethylhexanoat), Triethylenglykol-bis-(2-ethylhexanoat), Triethylenglykol-bis-(2-ethylbutanoat), Tetraethylenglykol-bis-n-heptanoat, Triethylenglykol-bis-n-heptanoat, Triethylenglykol-bis-n-hexanoat und/oder Tetraethylenglykoldimethylether
- Phosphate mit aliphatischen Esteralkoholen wie z.B. Tris(2-ethylhexyl)phosphat (TOF), Triethylphosphat
- Ester der Zitronensäure, Bernsteinsäure und/oder Fumarsäure
- Didiisononyladipat (DINA und Di2-butoxyethyladipat (DBEA)

Ganz besonders geeignet als Weichmacher für die erfindungsgemäßen Folien sind nicht-aromatische Weichmacher, deren Polarität, ausgedrückt durch die Formel 100 x O/(C+H) kleiner/gleich 9,4 ist, wobei O, C und H für die Anzahl der Sauerstoff-, Kohlenstoff- und Wasserstoffatome im jeweiligen Molekül steht. Die nachfolgende Tabelle zeigt erfindungsgemäß einsetzbare Weichmacher und deren Polaritätswerte nach der Formel 100 x O/(C+H).

| Name | 100 x O/(C+H) |
|---|---|
| Di-2-ethylhexylsebacat (DOS) | 5,3 |
| Di-2-ethylhexyladipat (DOA) | 6,3 |
| Triethylenglykol-bis-2-propylhexanoat | 8,6 |
| Triethylenglykol-bis-i-nonanoat | 8,6 |
| Di-2-butoxyethylsebacat (DBES) | 9,4 |
| Triethylenglykol-bis-2-ethylhexanoat (3G8) | 9,4 |
| 1,2 Cyclohexandicarbonsäurediisononylester (DINCH) | 5,4 |

Zusätzlich können die erfindungsgemäßen Folien weitere, dem Fachmann bekannte Zusätze enthalten wie Restmengen an Wasser, UV-Absorber, Antioxidantien, Haftungsregulatoren, optische Aufheller, Stabilisatoren, Farbmittel, Verarbeitungshilfsmittel, organische oder anorganische Nanopartikel, pyrogene Kieselsäure und/oder oberflächenaktive Stoffe.

Als Haftungsregulatoren werden im Rahmen der vorliegenden Erfindung Verbindungen verstanden, mit der die Haftung von weichmacherhaltigen Polyvinylacetalfolien an Glasoberflächen eingestellt werden kann. Verbindungen dieser Art sind dem Fachmann bekannt; in der Praxis werden hierzu häufig Alkali- oder Erdalkalimetallsalze von organischen Säuren, wie z.B. Kalium/Magnesiumacetat eingesetzt.

Es ist ebenso möglich, dass die Folien zur Verbesserung der Steifigkeit 0,001 bis 20 Gew.% SiO₂, bevorzugt 1 bis 15 Gew.%, insbesondere 5 bis 10 Gew.%, ggf. gedopt mit Al₂O₃ oder ZrO₂ enthalten.

Erfindungsgemäße Folien weisen bevorzugt die industriell üblichen Gesamtdicken von z.B. 0,38, 0,76, 1,14 mm (d.h. Vielfache von 0,38 mm) auf.

Die Herstellung der erfindungsgemäßen Folien erfolgt in der Regel durch Extrusion, die unter bestimmten Bedingungen (Schmelzedruck, Schmelzetemperatur und Werkzeugtemperatur) unter Erhalt einer Schmelzbruchoberfläche, d.h. einer stochastischen Oberflächenrauheit liefern.

Alternativ kann einer bereits hergestellten erfindungsgemäßen Zwischenschichtfolie durch einen Prägevorgang zwischen mindestens einem Walzenpaar eine regelmäßige, nicht stochastische Rauhigkeit aufgeprägt werden. Geprägte Folien weisen in der Regel ein verbessertes Entlüftungsverhalten bei der Verbundglasherstellung auf und werden bevorzugt im Automobilbereich eingesetzt.

Die prinzipielle Herstellung und Zusammensetzung von Folien auf Basis von Polyvinylacetalen ist z. B. in EP 185 863 B1, EP 1 118 258 B1 WO 02/102591 A1, EP 1 118 258 B1 oder EP 387 148 B1 beschrieben.

Erfindungsgemäße Folien weisen unabhängig vom Herstellverfahren eine einseitig oder besonders bevorzugt beidseitig aufgebrachte Oberflächenstruktur mit einer Rauhigkeit R_{Z} von 15 bis 150 µm, bevorzugt R_{z} von 15 bis 100 µm, besonders bevorzugt R_{z} von 20 bis 80 µm und insbesondere R_{z} von 40 bis 75 µm auf.

Erfindungsgemäße Folien sind auch zur Herstellung von Glas/Folie/Kunststoff-Laminaten, wie etwa zur dauerhaften Verklebung einer Glasscheibe mit einer PET-Schicht gut geeignet. Auch das Verkleben zweier Kunststoffscheiben, etwa aus Polycarbonat oder PMMA ist mit den erfindungsgemäßen Folien durchführbar.

Die erfindungsgemäßen Folien können insbesondere zur Herstellung von Verbundsicherheitsgläsern durch Laminieren mit einer oder mehreren Glasscheiben in dem Fachmann bekannter Weise verwendet werden. Die Verbundsicherheitsgläser können im Automobilbereich, z.B. als Windschutzscheibe, als auch im Architekturbereich z.B. in Fenstern oder transparenten Fassadenbauteilen oder im Möbelbau verwendet werden.

Eine weitere Verwendung der erfindungsgemäßen Folien besteht in der Herstellung von Photovoltaikmodulen.

### Messmethoden

Die Esterzahl EZ von Polyvinylalkohol wird gemäß DIN EN ISO 3681 bestimmt. Der Hydrolysegrad HG errechnet sich aus der Esterzahl wie folgt: HG [Gew.%] = 100* (100 - 0,1535*EZ)/(100 - 0,0749*EZ)

Die Bestimmung des Polyvinylalkohol- und Polyvinylacetatgehaltes von PVB erfolgt gemäß ASTM D 1396-92. Der Acetalysierungsgrad (= Butyralgehalt) kann als der zu Hundert fehlende Teil aus der gemäß ASTM D 1396-92 bestimmten Summe aus Polyvinylalkohol- und Polyvinylacetatgehalt berechnet werden. Die Umrechnung von Gew.% in Gew.% erfolgt gemäß dem Fachmann bekannten Formeln.

Der Weichmachergehalt der Folien wird durch Lösen der Folie in Ethanol und anschließende quantitative Gaschromatographie ermittelt. Um den Weichmachergehalt der Teilfolien zu ermitteln müssen die Mehrschichtfolien nach einer Konditionierungszeit von ca. 1 Woche d.h. nach weitgehendem Abschluss der Weichmachermigration wieder getrennt und einzeln vermessen werden.

Die Bestimmung der Glasübergangstemperatur des teilacetalisierten Polyvinylalkohols erfolgt mittels Dynamischer Differenzkalorimetrie (DSC) gemäß DIN 53765 unter Verwendung einer Heizrate von 10K/min im Temperaturintervall - 50 °C - 150°C. Es wird eine erste Heizrampe, gefolgt von einer Kühlrampe, gefolgt von einer zweiten Heizrampe gefahren. Die Lage der Glasübergangstemperatur wird an der der zweiten Heizrampe zugehörigen Messkurve nach DIN 51007 ermittelt. Der DIN-Mittelpunkt (Tg DIN) ist definiert als Schnittpunkt einer Horizontalen auf halber Stufenhöhe mit der Messkurve. Die Stufenhöhe ist durch den vertikalen Abstand der beiden Schnittpunkte der Mitteltangente mit den Basislinien der Messkurve vor und nach Glasumwandlung definiert.

Die Bestimmung des Trübungspunktes wird durch die Löslichkeit des Polvinylacetals in dem zu untersuchenden Weichmacher bestimmt. Hierzu wird Polyvinylacetal (8 g) in dem entsprechenden Weichmacher (100 g) suspendiert und unter ständiger Rührung bis zum Erhalt einer klaren Lösung erwärmt. Nach Erreichen des Klarpunktes wird die Lösung auf einem zweiten Rührer langsam auf Raumtemperatur abgekühlt. Durch ein in die Lösung ragendes Thermometer kann der Trübungspunkt optisch bestimmt werden.

### Messung der Zugeigenschaften der Folien

Die Werte für die Reißfestigkeiten der Folie wurden mittels Zugprüfmaschine (Fa.TIRA) gemäß ISO 527 bei einer Geschwindigkeit von 200 mm/min bestimmt.

Die Messung des spezifischen Durchgangswiderstandes der Folie (Elektrischer Durchgangswiderstand) erfolgt gemäß DIN IEC 60093 bei definierter Temperatur und Umgebungsfeuchte (23 °C und 85 % rLF bzw. 23% rLF) nachdem die Folie wenigstens 24h bei diesen Bedingungen konditioniert wurde. Zur Durchführung der Messung wurde eine Plattenelektrode Typ 302 132 von der Firma Fetronic GmbH sowie ein Widerstandsmessgerät ISO-Digi 5kV von der Firma Amprobe verwendet. Die Prüfspannung betrug 2,5 kV, die Wartezeit nach Anlegen der Prüfspannung bis zur Messwerterfassung 60 sek. Damit ein ausreichender Kontakt zwischen den flachen Platten der Messelektrode und der Folie gewährleistet ist, sollte deren Oberflächenrauhikgkeit R_{z} bei Messung nach DIN EN ISO 4287 nicht größer als 10 µm sein, d.h. gegebenenfalls muss die Originaloberfläche der PVB-Folie vor der Widerstandsmessung durch thermisches Umprägen geglättet werden.

Der Wasser- bzw. Feuchtegehalt der Folien wird mit der Karl-Fischer-Methode bestimmt. Zur Simulation des Auffeuchteverhaltens unter humiden Bedingungen wird die Folie zuvor 24h bei 23 °C und 85% rF bzw 23 % rF gelagert.

Das Ausschwitzen von Weichmacher wird nach einwöchiger Lagerung eines Films bei 23°C und 50% relativer Feuchte visuell bestimmt.

### Beispiele

1) Polyvinyl(n)acetal mit einem Polyvinylakoholgehalt von 20,3 Gew.%
   100 Gewichtsteile des Polyvinylalkohols Mowiol 28-99 (Handelsprodukt von Kuraray Europe GmbH) wurden in 975 Gewichtsteilen Wasser unter Erwärmen auf 90 °C gelöst. Es wurden bei einer Temperatur von 40 °C 57,5 Gewichtsteile n-Butyraldehyd und bei einer Temperatur von 12 °C unter Rühren 75 Gewichtsteile 20 %ige Salzsäure zugegeben. Die Mischung wurde nach Ausfallen des Polyvinylbutyrals (PVB) auf 73°C erwärmt und bei dieser Temperatur für 2 Stunden gerührt. Das PVB wurde nach Abkühlen auf Raumtemperatur abgetrennt, mit Wasser neutral gewaschen und getrocknet. Es wurde ein PVB mit einem Polyvinylakoholgehalt von 20,3 Gew.% und einem Polyvinylacetatgehalt von 0,9 Gew.% erhalten.
2) Polyvinyl(n)acetal mit einem Polyvinylakoholgehalt von 11,9 Gew.%
   100 Gewichtsteile des Polyvinylalkohols Mowiol 30-92 (Handelsprodukt von Kuraray Europe GmbH) wurden in 975 Gewichtsteilen Wasser unter Erwärmen auf 90 °C gelöst. Es wurden bei einer Temperatur von 40 °C 66,6 Gewichtsteile n-Butyraldehyd und 0,06 Gewichtsteile Glutardialdehyd b bei einer Temperatur von 12 °C unter Rühren 100 Gewichtsteile 20 %ige Salzsäure zugegeben. Die Mischung wurde nach Ausfallen des Polyvinylbutyrals (PVB) auf 69°C erwärmt und bei dieser Temperatur für 2 Stunden gerührt. Das PVB wurde nach Abkühlen auf Raumtemperatur abgetrennt, mit Wasser neutral gewaschen und getrocknet. Es wurde ein PVB mit einem Polyvinylakoholgehalt von 11,9 Gew.% und einem Polyvinylacetatgehalt von 8,8 Gew.% erhalten.
3-4) Polyvinyl(n)acetal mit einem Polyvinylakoholgehalt von 14,1 Gew% bzw. 15,1 Gew%
   Die Synthesen wurden gemäß Beispiel 2 durchgeführt, wobei die n-Butyraldehydmenge variiert wurde. Es wurden 56,8 bzw. 55,8 Gewichtsteile n-Butyraldehyd eingesetzt. Dementsprechend wurde ein Polyvinylalkoholgehalt von 14,1 Gew% bzw. 15,1 Gew% erhalten.
5) Polyvinyl(n)acetal mit einem Polyvinylakoholgehalt von 14,5 Gew%
   100 Gewichtsteile des Polyvinylalkohols Mowiol 28-99 (Handelsprodukt von Kuraray Europe GmbH) wurden in 975 Gewichtsteilen Wasser unter Erwärmen auf 90 °C gelöst. Es wurden bei einer Temperatur von 40 °C 67,4 Gewichtsteile n-Butyraldehyd und 0,055 Gewichtsteile Glutardialdehyd bei einer Temperatur von 12 °C unter Rühren 100 Gewichtsteile 20 %ige Salzsäure zugegeben. Die Mischung wurde nach Ausfallen des Polyvinylbutyrals (PVB) auf 69°C erwärmt und bei dieser Temperatur für 2 Stunden gerührt. Das PVB wurde nach Abkühlen auf Raumtemperatur abgetrennt, mit Wasser neutral gewaschen und getrocknet. Es wurde ein PVB mit einem Polyvinylakoholgehalt von 14,5 Gew.% und einem Polyvinylacetatgehalt von 1,1 Gew.% erhalten.
6) Polyvinyl(n)acetal mit einem Polyvinylakoholgehalt von 16,0 Gew%
   Die Synthese wurden gemäß Beispiel 5 durchgeführt, wobei die n-Butyraldehydmenge variiert wurde. Es wurden 62 Gewichtsteile n-Butyraldehyd eingesetzt. Dementsprechend wurde ein Polyvinylalkoholgehalt von 16,0 Gew% erhalten.
7) Polyvinyl(iso)acetal mit einem Polyvinylakoholgehalt von 20,3 Gew%
   100 Gewichtsteile des Polyvinylalkohols Mowiol 28-99 (Handelsprodukt von Kuraray Europe GmbH) wurden in 975 Gewichtsteilen Wasser unter Erwärmen auf 90 °C gelöst. Es wurden bei einer Temperatur von 40 °C 57,6 Gewichtsteile iso-Butyraldehyd und bei einer Temperatur von 12 °C unter Rühren 75 Gewichtsteile 20 %ige Salzsäure zugegeben. Die Mischung wurde nach Ausfallen des Polyvinylbutyrals (PVB) auf 73°C erwärmt und bei dieser Temperatur für 2 Stunden gerührt. Das PVB wurde nach Abkühlen auf Raumtemperatur abgetrennt, mit Wasser neutral gewaschen und getrocknet. Es wurde ein PVB mit einem Polyvinylakoholgehalt von 20,3 Gew.% und einem Polyvinylacetatgehalt von 1,2 Gew.% erhalten.
8) Polyvinyl(iso)acetal mit einem Polyvinylakoholgehalt von 14,4 Gew%
   100 Gewichtsteile des Polyvinylalkohols Mowiol 30-92 (Handelsprodukt von Kuraray Europe GmbH) wurden in 975 Gewichtsteilen Wasser unter Erwärmen auf 90 °C gelöst. Es wurden bei einer Temperatur von 40 °C 68,6 Gewichtsteile iso-Butyraldehyd und 0,06 Gewichtsteile Glutardialdehyd bei einer Temperatur von 12 °C unter Rühren 100 Gewichtsteile 20 %ige Salzsäure zugegeben. Die Mischung wurde nach Ausfallen des Polyvinylbutyrals (PVB) auf 69°C erwärmt und bei dieser Temperatur für 2 Stunden gerührt. Das PVB wurde nach Abkühlen auf Raumtemperatur abgetrennt, mit Wasser neutral gewaschen und getrocknet. Es wurde ein PVB mit einem Polyvinylakoholgehalt von 14,4 Gew.% und einem Polyvinylacetatgehalt von 8,7 Gew.% erhalten.
9-11) Polyvinyl(iso)acetal mit einem Polyvinylakoholgehalt von 15,6 Gew%, 16,4 Gew% bzw. 17,9 Gew%
   Die Synthesen wurden gemäß Beispiel 8 durchgeführt, wobei die iso-Butyraldehydmenge variiert wurde. Es wurden 67,6, 66,6 bzw. 60,8 Gewichtsteile iso-Butyraldehyd eingesetzt. Dementsprechend wurde ein Polyvinylalkoholgehalt von 15,6 Gew%, 16,4 Gew% bzw. 17,9 Gew% erhalten.
12) Polyvinyl(iso)acetal mit einem Polyvinylakoholgehalt von 15,8 Gew%
   100 Gewichtsteile des Polyvinylalkohols Mowiol 28-99 (Handelsprodukt von Kuraray Europe GmbH) wurden in 975 Gewichtsteilen Wasser unter Erwärmen auf 90 °C gelöst. Es wurden bei einer Temperatur von 40 °C 65 Gewichtsteile iso-Butyraldehyd und 0,055 Gewichtsteile Glutardialdehyd bei einer Temperatur von 12 °C unter Rühren 170 Gewichtsteile 20 %ige Salzsäure zugegeben. Die Mischung wurde nach Ausfallen des Polyvinylbutyrals (PVB) auf 69°C erwärmt und bei dieser Temperatur für 1 Stunde gerührt. Das PVB wurde nach Abkühlen auf Raumtemperatur abgetrennt, mit Wasser neutral gewaschen und getrocknet. Es wurde ein PVB mit einem Polyvinylakoholgehalt von 15,8 Gew.% und einem Polyvinylacetatgehalt von 0,9 Gew.% erhalten.
13) Polyvinyl(iso)acetal mit einem Polyvinylakoholgehalt von 16,3 Gew%
   Die Synthese wurden gemäß Beispiel 12 durchgeführt, wobei die iso-Butyraldehydmenge variiert wurde. Es wurden 64 Gewichtsteile iso-Butyraldehyd eingesetzt. Dementsprechend wurde ein Polyvinylalkoholgehalt von 16,3 Gew% erhalten.
14) Polyvinyl(iso)acetal mit einem Polyvinylakoholgehalt von 18,2 Gew%
   100 Gewichtsteile des Polyvinylalkohols Mowiol 28-99 (Handelsprodukt von Kuraray Europe GmbH) wurden in 975 Gewichtsteilen Wasser unter Erwärmen auf 90 °C gelöst. Es wurden bei einer Temperatur von 40 °C 60,8 Gewichtsteile iso-Butyraldehyd und bei einer Temperatur von 12 °C unter Rühren 75 Gewichtsteile 20 %ige Salzsäure zugegeben. Die Mischung wurde nach Ausfallen des Polyvinylbutyrals (PVB) auf 73°C erwärmt und bei dieser Temperatur für 2 Stunden gerührt. Das PVB wurde nach Abkühlen auf Raumtemperatur abgetrennt, mit Wasser neutral gewaschen und getrocknet. Es wurde ein PVB mit einem Polyvinylakoholgehalt von 18,2 Gew.% und einem Polyvinylacetatgehalt von 0,9 Gew.% erhalten.
14-17) Polyvinyl(iso)acetal mit einem Polyvinylakoholgehalt von 18,2 Gew%, 19,4 Gew%, 20,5 Gew% bzw. 22,3 Gew%
   Die Synthese wurden gemäß Beispiel 14 durchgeführt, wobei die iso-Butyraldehydmenge variiert wurde. Es wurden 60,8, 59,4, 57,5 bzw. 55,4 Gewichtsteile iso-Butyraldehyd eingesetzt. Dementsprechend wurde ein Polyvinylalkoholgehalt von 18,2 Gew%, 19,4 Gew%, 20,5 Gew% bzw. 22,3 Gew% erhalten.

### Herstellung von Folien

Es wurden Folien der Zusammensetzung gemäß Tabelle 1 durch Extrusion hergestellt.

In Tabelle 1 ist zu sehen, dass erfindungsgemäße Folien bei gleichem PVA- und Weichmachergehalt gegenüber den Vergleichsfolien auf Basis n-Butanal eine höhere Erweichungstemperatur besitzen. Die Weichmacherverträglichkeit bei vergleichbarem PVA-Gehalt ist in erfindungsgemäßen Folien besser, wie in den Beispielen 6 und 7 bzw. 2 und 3 gezeigt ist.

Tabelle 2 zeigt physikalische Daten der Folien. Es zeigt sich, dass erfindungsgemäße Folien eine niedrigere Feuchteaufnahme bei gleichem PVA-Gehalt und Weichmachergehalt aufweisen. Außerdem wird deutlich, dass erfindungsgemäße Folien einen deutlich höheren elektrischen Durchgangswiderstand aufweisen als vergleichbare Folien auf Basis n-Butanal, was für den Einsatz in Solarmodulen vorteilhaft ist.

Die mechanischen Eigenschaften erfindungsgemäßer Folien können durch die Verwendung von Poly(iso)acetalen gut über den Weichmacher als auch den PVA-Gehalt eingestellt werden. An Beispiel 1 und 7 ist zu sehen, dass bei gleichem PVA- und Weichmachergehalt annähernd gleiche Reißfestigkeiten erhalten werden.

Es bedeuten in den Tabellen

| | |
|---|---|
| 3G8 | Triethylenglykol-bis-2-ethylhexanoat |
| DINCH | 1,2 Cyclohexandicarbonsäurediisononylester |
| DINA | Didiisononyladipat |
| DBEA: | Di2-butoxyethyladipat |

In Mischungen wurden im Gewichtsverhältnis 3G8:DBEA = 10:1; DINCH:DINA = 1:1 verwendet.

Trübung: Trübungspunkt in 3G8 [°C]

PVA: Anteil an Polyvinylalkoholgruppen in [Gew%]

WM-gehalt Weichmachergehalt [Gew%]

Ausschwitzen Weichmacher-Ausschwitzen (visuell)

**Tabelle 1**

| Beispiel | Aldehyd | PVA | Weichmacher* | WM-gehalt | Tg [°C] | Trübung | Ausschwitzen |
|---|---|---|---|---|---|---|---|
| 1 | n-Butanal | 20,3 | 3G8 / DBEA | 27,5 | 19,1 | 132,5 | nein |
| 2 | n-Butanal | 11, 9 | | | | 54 | |
| 3 | n-Butanl | 14, 1 | 3G8 / DBEA | 39 | -6,02 | 56 | ja |
| 4 | n-Butanal | 15,1 | 3G8 / DBEA | 39 | -4, 60 | | ja |
| 5 | n-Butanal | 14,5 | DINCH / DINA | 28 | 14,34 | | nein |
| 6 | n-Butanal | 16,0 | | | | 78 | |
| 7 | Iso-Butanal | 20,3 | 3G8 / DBEA | 27,5 | 20,48 | 97,5 | nein |
| 8 | Iso-Butanal | 14,4 | 3G8 / DBEA | 39 | -7,65 | | nein |
| 9 | Iso-Butanal | 15, 6 | 3G8 / DBEA | 39 | -10,09 | | nein |
| 10 | Iso-Butanal | 16,4 | 3G8 / DBEA | 39 | -8, 65 | | nein |
| 11 | Iso-Butanal | 17, 9 | 3G8 / DBEA | 39 | -6,44 | | nein |
| 8 | Iso-Butanal | 14,4 | 3G8 / DBEA | 37,5 | -8,73 | | nein |
| 9 | Iso-Butanal | 15, 6 | 3G8 / DBEA | 37,5 | -7, 98 | | nein |
| 10 | Iso-Butanal | 16,4 | 3G8 / DBEA | 37,5 | -8,54 | | nein |
| 11 | Iso-Butanal | 17, 9 | 3G8 / DBEA | 37,5 | -4,40 | | nein |
| 12 | Iso-Butanal | 15,8 | DINCH / DINA | 28 | 20,34 | 42 | nein |
| 13 | Iso-Butanal | 16,3 | DINCH / DINA | 28 | 17,44 | 53 | nein |
| 14 | Iso-Butanal | 18,2 | DINCH / DINA | 28 | 21,06 | 81 | nein |
| 15 | Iso-Butanal | 19,4 | DINCH / DINA | 28 | 23,77 | 93,5 | nein |
| 16 | Iso-Butanal | 20.5 | 3G8 / DBEA | 28,2 | 18,76 | 104 | nein |
| 17 | Iso-Butanal | 22.3 | 3G8 / DBEA | 28,8 | 19,17 | 123 | nein |

**Tabelle 2**

| Beispie 1 | Reißfestigkeit [N/mm2] | Elektrischer Durch-gangswiderstand 23% rF [Ohm x cm] | Elektrischer Durch-gangswiderstand 85% rF [Ohm x cm] | Wassergehalt bei 23% rF | Wassergehalt bei 85% rF |
|---|---|---|---|---|---|
| 1 | 29,8 | 1_{,}2 x 10¹¹ | 5, 6 x 10¹⁰ | 0,46 | 2,51 |
| 7 | 30,1 | 9,6 x 10¹² | 5,6 x 10¹¹ | 0,41 | 2,38 |
| 14 | 28,5 | 3,4 x 10¹² | 9,5 x 10¹⁰ | 0,42 | 2,31 |
| 15 | 29,8 | 1,1 x 10¹² | 1,6 x 10¹¹ | 0,45 | 2,5 |

## Patentansprüche

1. Folie enthaltend eine Mischung aus mindestens einem nicht-aromatischen Weichmacher und einem Polyvinyl(iso)acetal mit einem Anteil an Polyvinyl(iso)acetalgruppen von 60 - 85 Gew.% und einem Anteil an Polyvinylalkoholgruppen von 14 - 40 Gew.%.

2. Folie nach Anspruch 1 **dadurch gekennzeichnet** das nicht-aromatische Weichmacher mit einer Polarität, ausgedrückt durch die Formel 100 x O/(C+H), kleiner/gleich 9,4 eingesetzt werden.

3. Folie nach Anspruch 1 oder 2, **dadurch gekennzeichnet** das nicht-aromatische Weichmacher ausgewählt aus der Gruppe Di-2-ethylhexylsebacat (DOS), Di-2-ethylhexyladipat (DOA), Di-2-ethylhexylphthalat (DOP), Triethylenglykol-bis-2-propylhexanoat, Triethylenglykol-bis-i-nonanoat, Di-2-butoxyethylsebacat (DBES), Triethylenglykol-bis-2-ethylhexanoat (3G8), 1,2 Cyclohexandicarbonsäurediisononylester (DINCH) eingesetzt werden.

4. Folie nach einem der Ansprüche 1 bis 3, **dadurch gekennzeichnet, dass** die Polyvinyl(iso)acetalgruppen des Polyvinyl(iso)acetals aus der Umsetzung von mindestens einem Polvinylalkohol mit einer oder mehreren aliphatischen Ketoverbindung mit 4 bis 10 Kohlenstoffatomen mit mindestens einer Verzweigung an der alpha- oder beta-Position zur Ketogruppe resultieren.

5. Folie nach einem der Ansprüche 1 bis 4, **dadurch gekennzeichnet, dass** das Polyvinyl(iso)acetal einen Anteil an Polyvinylacetatgruppen von 0,1 bis 15 Gew.% enthält.

6. Verwendung der Folie nach einem der Ansprüche 1 bis 5 im Automobilbereich, in Windschutzscheiben, im Architekturbereich, in Fassadenbauteilen oder zur Herstellung von Photovoltaikmodulen.
